Europäisches Patentamt

European Patent Office

Office européen des brevets

(11) Veröffentlichungsnummer: **0 288 422 B1**

## (12) EUROPÄISCHE PATENTSCHRIFT

(45) Veröffentlichungstag der Patentschrift: **16.06.93**

(21) Anmeldenummer: **88730088.7**

(22) Anmeldetag: **18.04.88**

(51) Int. Cl.⁵: **H03K 17/10**, H03K 17/08, H03K 17/12, H03K 17/73

(54) **Vergleichmässigung der Spannungsaufteilung beim Abschalten einer Reihenschaltung gategesteuerter Halbleiter.**

(30) Priorität: **24.04.87 DE 3714173**

(43) Veröffentlichungstag der Anmeldung:
**26.10.88 Patentblatt 88/43**

(45) Bekanntmachung des Hinweises auf die
Patenterteilung:
**16.06.93 Patentblatt 93/24**

(84) Benannte Vertragsstaaten:
**AT DE ES FR IT**

(56) Entgegenhaltungen:
**EP-A- 0 043 489      EP-A- 0 048 758
EP-A- 0 110 461      EP-A- 0 140 349
EP-A- 0 202 962      EP-A- 0 215 707
DE-A- 3 316 402      GB-A- 2 007 451
GB-A- 2 032 721**

**PATENT ABSTRACTS OF JAPAN, unexamined applications, E Sekfion, Band 4, Nr. 36,
26. März 1980 THE PATENT OFFICE JAPANE-
SE GOVERNMENT Seite 91 E 3**

**Patent Abstract of Japan, Band 11,
No.7,(E469)(2454), 9.Januar 1987 & JP-A
61182281**

Patent Abstract of Japan, Band 4, No.63,
13.März 1980 & JP-A 55033313

(73) Patentinhaber: **Licentia Patent-
Verwaltungs-GmbH
Theodor-Stern-Kai 1
W-6000 Frankfurt/Main 70(DE)**

(72) Erfinder: **Beinhold, Georg
Kaulbachstrasse 20a
W-1000 Berlin 46(DE)**
Erfinder: **Niehage, Helmut
Thomas-Dehler-Strasse 3
W-1000 Berlin 30(DE)**

(74) Vertreter: **Lertes, Kurt, Dr. et al
Licentia Patent-Verwaltungs-GmbH Theodor-
Stern-Kai 1
W-6000 Frankfurt/M 70 (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Verfahren gemäß dem Oberbegriff des Anspruchs 1 sowie eine Schaltungsanordnung zur Durchführung dieses Verfahrens. Ein derartiges Verfahren ist durch No. 55-33313 A der Patents Abstracts of Japan Sect. E, Vol. 4 (1980) No. 63 (E10) bekannt.

Unter gategesteuerten Halbleitern sollen hier sämtliche Halbleiterschalter verstanden sein, die über ihren Steueranschluß (Gate) sowohl ein- als auch ausgeschaltet werden können, wie z. B. feldsteuerbare Transistoren (Injected Gate Transistor) oder GTO-Thyristoren.

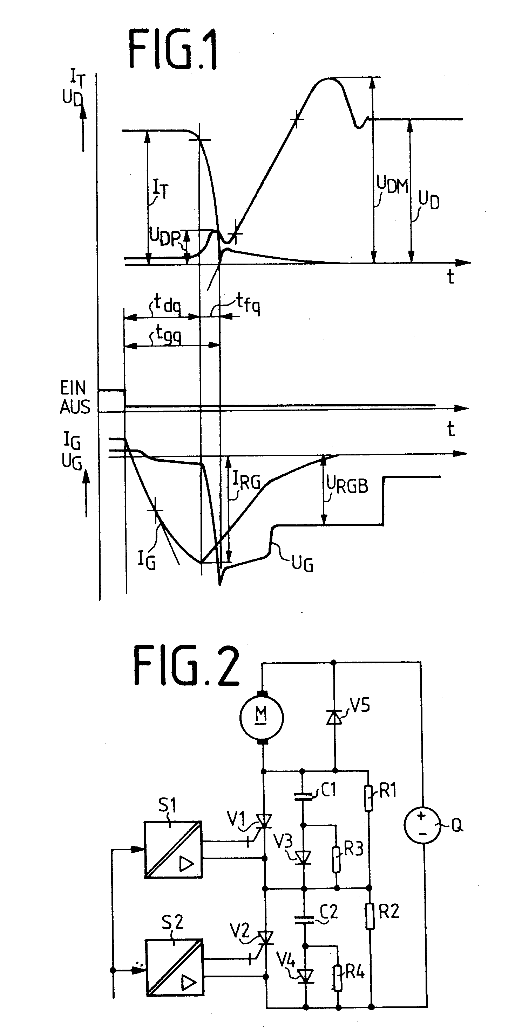

Die Spannungs- und Stromverhältnisse im Anoden-Kathodenkreis sowie im Gate-Kathodenkreis beim Ausschalten eines GTO-Thyristors sind in Fig. 1 zusammen mit dem zeitlichen Verlauf des Schaltbefehls dargestellt. Mit dem Umschalten des Schaltbefehls von "EIN" auf "AUS" wird durch die Steuerschaltung ein Abschaltsignal in Form eines negativen Gate-Stromes $I_G$ über die Gate-Kathodenstrecke des GTO-Thyristors getrieben. Der Gate-Strom $I_G$ steigt bis zu einer Gate-Rückwärtssteuerstromspitze $I_{RG}$ an, um dann wieder auf Null abzufallen. Bei Erreichen dieser Gate-Rückwärtssteuerstromspitze $I_{RG}$ springt die Gate-Spannung $U_G$ steil an, um dann schließlich auf die Gate-Rückwärtssteuerspannung $U_{RGB}$ abzufallen. Während des Abschaltvorgangs fließt zunächst im Anoden-Kathodenkreis des GTO-Thyristors der Anodenstrom $I_T$ weiter, bis er schließlich im zeitlichen Bereich der Gate-Rückwärtssteuerstromspitze $I_{RG}$ steil auf einen sogenannten Schweifstrom abfällt. Die Zeit von der Abgabe des "AUS" Schaltbefehls bis zum steilen Abfall des Anodenstroms wird als Abschaltverzugszeit $t_{dq}$ bezeichnet. Die Zeit des Abfalls des Anodenstroms $I_T$ bis zum Schweifstrom bezeichnet man als Abschaltfallzeit $t_{fq}$. Die Summe aus der Abschaltverzugszeit $t_{dq}$ und der Abschaltfallzeit $t_{fq}$ ist die Abschaltzeit $t_{gq}$ des GTO-Thyristors. Die Gleichspannungs $U_D$ am GTO-Thyristor steigt während der Abfallzeit des Anodenstromes $I_T$ zunächst auf den Wert der sogenannten Nadelspannung $U_{DP}$ steil an, um dann im weiteren Verlauf des Abschaltvorgangs bis zu der Spitzenspannung $U_{DM}$ weiter hochzulaufen. Im abgeschalteten Zustand liegt am GTO-Thyristor schließlich dann die Gleichspannung $U_D$.

Ist es nötig, wegen der hohen Versorgungsspannung $U_D$ eine Reihenschaltung von GTO-Thyristoren oder anderen gategesteuerten Halbleitern vorzunehmen, ist neben der stationären Spannungsaufteilung während der Sperrphase der Reihenschaltung auch auf die gleichmäßige Aufteilung der Spannung beim Abschalten der Halbleiter zu achten. Dies ist von besonderer Bedeutung, da die Abschaltverzugszeiten gategesteuerter Halbleiter und insbesondere von GTO-Thyristoren eine starke Exemplarstreuung aufweisen und sich auch in Abhängigkeit vom Anodenstrom, der Temperatur sowie weiterer Parameter ändern können.

In Fig. 2 ist das Prinzipschaltbild für eine Reihenschaltung zweier gategesteuerter Halbleiter V1, V2 in Form von GTO-Thyristoren gezeigt. Diese bilden einen Gleichstromsteller für eine aus einer Gleichspannungsquelle Q gespeiste, als Motor gezeigte Last M, der eine Freilaufdiode V5 antiparallelgeschaltet ist. Die Halbleiter V1, V2 sind in üblicher Weise beschaltet: Parallel zum Halbleiter V1 liegt die Reihenschaltung aus einem Beschaltungskondensator C1 und einer Beschaltungsdiode V3, der ein ohmscher Widerstand R3 parallelliegt; dem Halbleiter V2 liegt in gleicher Weise die Reihenschaltung eines Beschaltungskondensators C2 mit einer Beschaltungsdiode V4 parallel, wobei der Beschaltungsdiode V4 ein ohmscher Widerstand R4 parallelgeschaltet ist. Die Spannungsaufteilung an der Reihenschaltung der beiden Halbleiter V1, V2 wird im stationären Zustand durch die den Halbleitern V1, V2 parallelgeschalteten ohmschen Widerstände R1, R2 gewährleistet.

Die Ansteuerung der beiden gategesteuerten Halbleiter V1, V2 zum Einschalten und zum Abschalten erfolgt mittels zweier Steuerschaltungen S1, S2, die jeweils an den Steueranschluß und die Kathode des betreffenden Halbleiters angeschlossen sind.

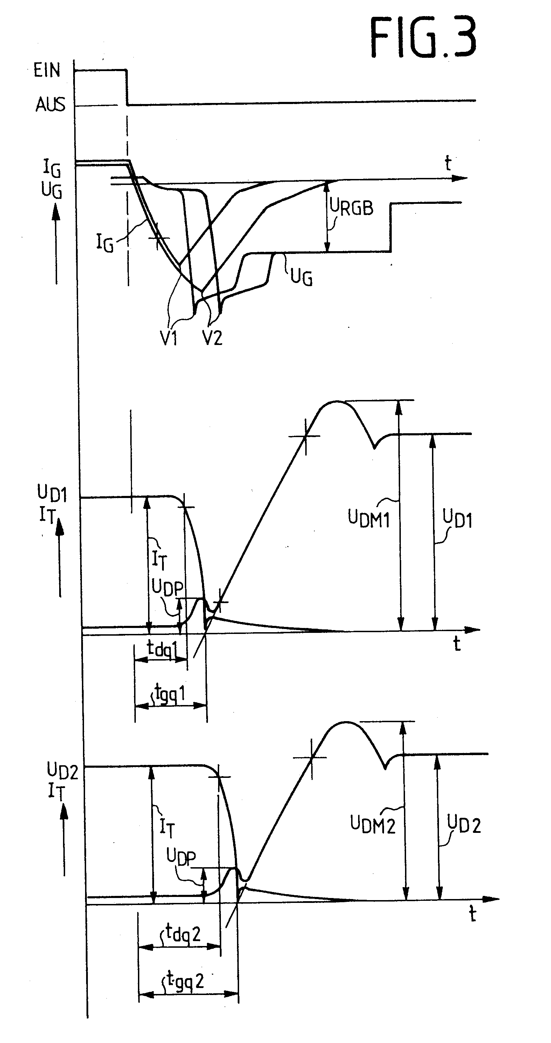

Wenn die beiden Halbleiter V1, V2 - wie in der Praxis üblich - verschieden lange Abschaltverzugszeiten aufweisen, kommutiert beim Abschalten der durch die Reihenschaltung fließende Laststrom zu verschiedenen Zeitpunkten in die parallel zu den Halbleitern V1, V2 liegenden Beschaltungskondensatoren C1, C2. Das bewirkt bei diesen Beschaltungskondensatoren C1, C2 verschiedene elektrische Ladungen und damit unterschiedliche Spannungen, die proportional zur Differenz der Ausschaltzeiten der beiden Halbleiter V1,V2 sind. In Fig. 3 sind die Strom- und Spannungsverläufe für die beiden Halbleiter V1, V2 dargestellt, wenn sie zur gleichen Zeit den Ausschaltbefehl erhalten, aber unterschiedliche Abschaltverzugszeiten und entsprechend auch unterschiedliche Abschaltzeiten aufweisen.

Man erkennt, daß das Abschaltsignal für den Halbleiter V1, nämlich der negative Gate-Strom $I_G$ zu einem früheren Zeitpunkt die Gate-Rückwärtssteuerstromspitze aufweist als der Gate-Strom $I_G$ des Halbleiters V2. Entsprechend früher springt die negative Gate-Kathodenspannung $U_G$ beim Halbleiter V1 an. Der Anodenstrom $I_T$ des Halbleiters V1 fällt nach einer kürzeren Abschaltverzugszeit $t_{dq1}$ zu seinem Schweifstrom ab, als der Anodenstrom $I_T$ des Halbleiters V2, der die Abschaltverzugszeit $t_{dq2}$ aufweist. Der Schweifstrom ist beim Halbleiter V1 bereits nach einer Abschaltzeit $t_{gq1}$ erreicht, während der Abschaltzeitpunkt des Halbleiters V2 erst nach der längeren Abschaltzeit $t_{gq2}$ auftritt.

Die entsprechend der Zeitdifferenz zwischen den beiden Abschaltzeiten $t_{gq1}$, $t_{gq2}$ stärkere Aufladung des Beschaltungskondensators C1 gegenüber dem Beschaltungskondensator C2 bewirkt eine Überspannung am Halbleiter V1. Wie aus Fig. 3 zu erkennen ist, liegt nämlich die Spitzenspannung $U_{DM1}$ am Halbleiter V1 erheblich über der Spitzenspannung $U_{DM2}$ des Halbleiters V2. In gleicher Weise bleibt auch nach dem Abklingen der Spitzenspannung die Gleichspannung $U_{D1}$ am Halbleiter V1 höher als die Gleichspannung $U_{D2}$ am Halbleiter V2. Die Gesamtspannung $U_D$ an der Reihenschaltung als Summe der beiden Gleichspannungen $U_{D1}$ und $U_{D2}$ ist ungleich verteilt.

Um die beschriebene Überspannungsbelastung an den gategesteuerten Halbleitern mit kleiner Abschaltzeit innerhalb der Reihenschaltung zu vermeiden, ist es notwendig, die Spannungsverteilung zu vergleichmäßigen.

Bei der Schaltungsanordnung nach No. 55-8225 (A) der Patents Abstracts of Japan Sect. E, Vol. 4 (1980), No. 36 (E-3) wird diese Spannungsvergleichmäßigung allein durch die Beschaltung der Halbleiter angestrebt. Dies zeigt aber in der Praxis aus den zuvor beschriebenen Gründen nur geringe Wirkung oder erfordert einen großen Aufwand an Kapazitäten bei den Beschaltungskondensatoren.

Bei dem eingangs bereits genannten Verfahren nach der JP 55-33313 A wird eine zeitliche Verschiebung der Abschaltsignale mit einer fest eingestellten Zeitstufe vorgenommen. Damit kann eine Symmetrierung der Spannungsaufteilung nur grob durchgeführt werden, da die Abschaltzeit der einzelnen gategesteuerten Halbleiter laststrom-, temperatur-, zeit- und exemplarabhängig ist.

Durch die EP-A 0202962 ist bereits ein Verfahren zur Angleichung der streuenden Abschaltzeiten von in Reihe geschalteten Transistoren bekannt, bei dem durch Abgabe der die Transistoren steuernden Abschaltsignale zum gleichen Zeitpunkt zunächst festgestellt wird, wann der jeweilige Halbleiter abschaltet. Dieses erfolgt durch einen Zeitvergleich der Signalflanken. Dann wird die Ausgabe der Abschaltsignale an die eher abschaltenden Halbleiter verzögert, so daß im stationären Fall nach einer gewissen Zeit alle Transistoren gleichzeitig abschalten.

Zur Durchführung dieses bekannten Verfahrens ist jedem Halbleiter ein Differenzzeitregler zugeordnet, dem eingangsseitig ein Signal zum (Ein- und) Abschalten des Halbleiters zuführbar ist und der eingangsseitig mit einem Spannungs-Differenzbildner verbunden ist. Ausgangsseitig ist der Differenzzeitregler an den Steueranschluß des Transistors angeschlossen, wobei das Ausgangssignal des Differenzzeitreglers entsprechend dem vom Spannungs-Differenzbildner abgegebenen Signal verzögert ist. Der Zeitvergleich der Signalflanken erfolgt über einen Integrator. Damit eilt die Vergleichsbildung und somit auch die Angleichung der Abschaltzeiten den tatsächlichen Verhältnissen, die sich insbesondere aufgrund der Laststrom - und Temperaturabhängigkeit bei den einzelnen Halbleitern ständig ändern, stets nach. Bei Transistoren ist diese Verzögerung oft noch hinnehmbar, bei GTO-Thyristoren jedoch muß um eine Zerstörung derselben zu vermeiden, sofort und unmittelbar wirkend eine genaue Korrektur der Spannungsaufteilung entlang der Reihenschaltung der Halbleiter einschließlich ihrer Beschaltung vorgenommen werden.

Durch die DE-A 33 16 402 ist es bekannt, bei einem Thyristor-Steller für Kondensator-Kompensationseinrichtungen den von der Last aufgezwungenen Strom-Nulldurchgang zu erfassen und zu Zwecken einer Schutzzündung bei Unsymmetrie heranzuziehen. Das Problem einer Vergleichmäßigung der Spannungsaufteilung entlang der Reihenschaltung von in ihren Abschaltzeiten variierender abschaltbarer Thyristoren durch Angleichung dieser Abschaltzeiten tritt hier jedoch nicht auf.

Der Erfindung liegt die Aufgabe zugrunde, unabhängig von den sich ändernden Abschaltzeiten der Halbleiter zu jedem Zeit- und Betriebspunkt eine optimale Spannungsaufteilung innerhalb der Reihenschaltung der Halbleiter zu erzielen.

Diese Aufgabe wird gemäß der Erfindung durch die im Anspruch 1 gekennzeichneten Merkmale gelöst.

Der Erfindungsgedanke entfernt sich von der bekannten starren Kompensation der unterschiedlichen Abschaltzeiten oder der zeitverzögerten Nachführung der Abschaltzeiten und schlägt auf vorteilhafte Weise eine Regelung auf symmetrische Spannungsaufteilung vor. Es wird die tatsächliche Amplitude der Anodenspannung unmittelbar mit dem zugehörigen Teil der Amplitude der Gesamtspannung verglichen und daraus eine Korrekturgröße gebildet, die ein Maß für die Zeitverschiebung ist. Das bedeutet, daß unabhängig von allen Möglichkeiten, die zur Veränderung der halbleitereigenen Abschaltzeit führen, die jeweils aktuellen Anodenspannungen als Regelgröße verwendet und folglich symmetriert werden.

Die verschiedenen Abschaltzeiten werden also durch Veränderung der Abschaltbefehlszeiten sofort genau kompensiert, was dazu führt, daß infolge der gleichzeitigen Abschaltung aller Halbleiter eine unterschiedliche Aufladung der Beschaltungskondensatoren nicht mehr erfolgen kann. Spannungsüberlastungen aufgrund unterschiedlicher Abschaltzeiten sind damit an den Halbleitern nicht mehr möglich. Eine symmetrische Spannungsaufteilung sowohl zu jedem Augenblick des Abschaltens als auch danach im stationären Sperrzustand der Reihenschaltung ist garantiert.

Vorteilhafte Ausgestaltungen des Verfahrens nach der Erfindung sowie Schaltungsanordnungen zur Durchführung dieses Verfahrens sind in den übrigen Ansprüchen gekennzeichnet.

Das Verfahren nach der Erfindung soll für ein Ausführungsbeispiel anhand der Zeichnung im folgenden erläutert werden. Es zeigt

Fig. 4 das Prinzipschaltbild einer Schaltungsanordnung zur Durchführung des Verfahrens nach der Erfindung mit einzelnen Differenzzeitreglern für die Halbleiter einer Reihenschaltung und

Fig. 5 den lastabhängigen Verlauf der Abschaltverzugszeit.

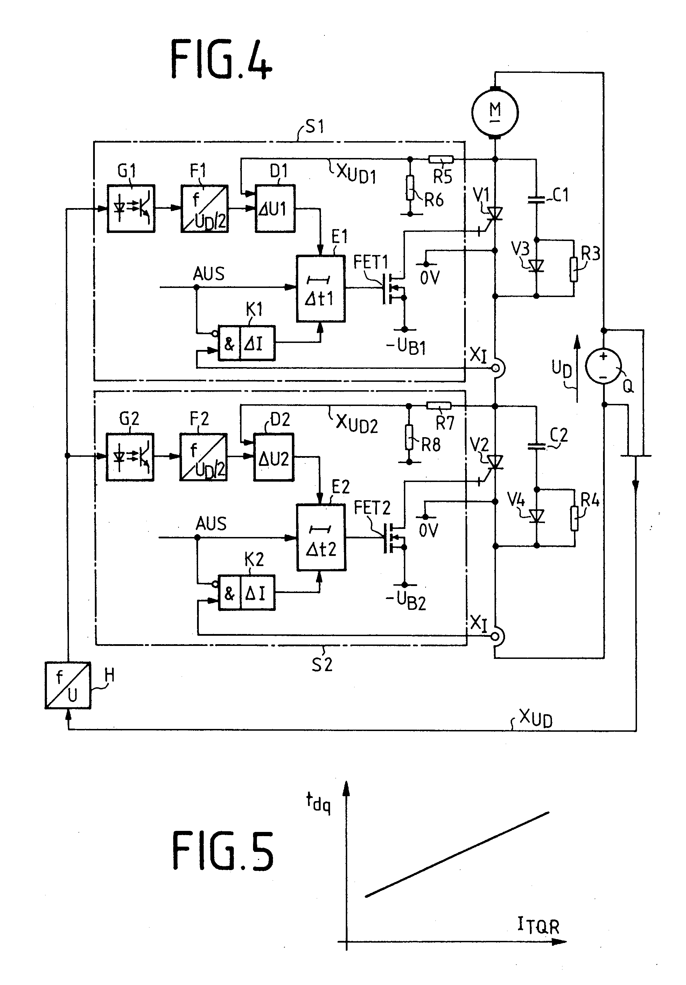

Durch die in Fig. 4 dargestellte Schaltungsanordnung werden die beiden in Reihe geschalteten, als GTO-Thyristoren ausgebildeten Halbleiter V1, V2 zum gleichen Zeitpunkt abgeschaltet, so daß sich an der Reihenschaltung der beiden Halbleiter V1, V2 eine sehr gleichmäßige Spannungsaufteilung beim Abschalten und auch während des stationären Sperrzustands ergibt. Der zum Einschalten der beiden Halbleiter V1, V2 notwendige Teil der Steuerschaltungen S1, S2 ist, da er zur Erläuterung der Erfindung nicht erforderlich ist, nicht gezeigt.

Zum Abschalten der beiden Halbleiter V1, V2 steuert ein dem jeweiligen Halbleiter V1, V2 zugeordneter, in seiner Funktionsweise später noch zu erläuternder Differenzzeitregler E1, E2 bei einem ihm zugeführten Signal "AUS" ein als Feldeffekttransistor ausgebildetes Schaltelement FET1, FET2 in den leitenden Zustand, so daß eine Spannungsquelle $-U_{B1}$, $-U_{B2}$ einen negativen Gate-Kathodenstrom durch den Halbleiter V1, V2 treibt.

Die Differenzzeitregler E1, E2 sind eingangsseitig jeweils mit einem Spannungs-Differenzbildner D1, D2 verbunden. Dem einen Eingang der Spannungs-Differenzbildner D1, D2 wird jeweils ein der tatsächlichen Spannung $U_{D1}$, $U_{D2}$ am betreffenden Halbleiter V1, V2 entsprechendes Signal $x_{UD1}$, $x_{UD2}$ zugeführt. Diese Signale können, wenn die Spannungs-Differenzbildner D1, D2 und die Differenzzeitregler E1, E2 von einer auf dem Kathodenpotential des jeweiligen Halbleiters V1, V2 liegenden (nicht näher gezeigten) Spannungsquelle gespeist werden, wie in Fig. 4 gezeigt, auf einfache Weise über direkt anodenseitig angeschlossene Spannungsteiler R5, R6 bzw. R7, R8 gewonnen werden.

Ein der Gesamtgleichspannung $U_D$ an der Reihenschaltung entsprechendes Signal $x_{UD}$ wird durch Spannungsabgriff an der speisenden Spannungsquelle Q gebildet und über einen Spannungsfrequenzumsetzer H, Optokoppler G1, G2 auf Frequenz-Spannungsumsetzer F1, F2 übertragen. Über die Optokoppler G1, G2 als Potentialtrennstärke müssen damit nur digitale Signale geführt werden.

Die Frequenz-Spannungsumsetzer F1, F2 teilen das eingangs erhaltene Signal im Verhältnis der Anzahl der in der Reihenschaltung vorhandenen Halbleiter. Im vorliegenden Fall bilden nur zwei Halbleiter V1, V2 die Reihenschaltung, so daß die Frequenz-Spannungsumsetzer F1, F2 die eingangs erhaltenen, der Spannung an der Reihenschaltung entsprechenden Signale halbieren. Am Ausgang des Frequenz-Spannungsumsetzers F1, F2 liegt damit ein Spannungswert an, der dem auf den einzelnen Halbleiter entfallenen Teil der Gesamtspannung $U_D$ entspricht. Dieser Wert wird auf den anderen Eingang des jeweiligen Spannungs-Differenzbildners D1, D2 gegeben.

Sofern die beiden Halbleiter V1, V2 unterschiedlich lange Abschaltzeiten haben, werden sich zunächst ihre parallelliegenden Beschaltungskondensatoren C1, C2 unterschiedlich stark aufladen, so daß an den einzelnen Halbleitern V1, V2 unterschiedliche Spannungen anliegen. Dementsprechend wird durch die Spannungs-Differenzbildner D1, D2 eine Differenzspannung $\Delta U_1 = U_{D1} - U_D/2$ bzw. $\Delta U_2 = U_{D2} - U_D/2$ gebildet.

Die von den Spannungs-Differenzbildnern ausgangsseitig abgegebenen Differenzspannungen $\Delta U$ bewirken, sofern die tatsächliche Spannung $U_{D1}$, $U_{D2}$ größer ist als der auf den Halbleiter bei gleichmäßiger Spannungsaufteilung entfallende Teil der Gesamtspannung $U_D$, beim zugehörigen Differenzzeitregler E1, E2 eine zeitlich verzögerte Ansteuerung des mit ihm verbundenen Feldeffekttransistors FET1, FET2. Die Verzögerung ist der entsprechenden positiven Spannungsdifferenz $\Delta U$ proportional.

Weist z. B. der Halbleiter V1 eine kürzere Abschaltzeit auf als der Halbleiter V2, ist die vom Spannungs-Differenzbildner D1 festgestellte Differenzspannung $\Delta U_1$ größer als Null. Die an den Differenzzeitregler E1 abgegebene Differenzspannung $\Delta U_1$ wirkt dann derart, daß der Differenzzeitregler E1 wegen der zu hohen tatsächlichen Spannung $U_{D1}$ an den mit ihm verbundenen Feldeffekttransistor FET1 einen gegenüber dem Abschaltbefehl "AUS" verzögerten Abschaltbefehl gibt, während der Feldeffekttransistor FET2 vom Differenzzeitregler E2 wie bisher beim Auftreten des Signals "AUS" sofort angesteuert wird.

Diese Korrektur wird laufend durchgeführt, so daß auch durch Veränderungen der Einfluß auf die Abschaltzeit der Halbleiter nehmenden Parameter keine Unsymmetrien entstehen können.

Die Widerstände (R1, R2 in Fig. 2) für eine stationäre Spannungsaufteilung entlang der Reihenschaltung der Halbleiter können entfallen bzw. sehr hochohmig werden, da auch hier die Regelung nach der Erfindung eingreift.

Ebenfalls mit ausgeregelt werden die unterschiedlichen Trägerstauladungen der Beschaltungsdioden V3 und V4 sowie die Kapazitätstoleranzen der Beschaltungskondensatoren C1, C2, da diese Differenzen ebenfalls zu Spannungsunsymmetrien führen.

Gestartet wird die beschriebene Regelung auf Spannungssymmetrie bei kleinen Strömen durch die Halbleiter V1, V2, um eine Voreinstellung (Grobabgleich) bei ungefährlichen Werten der Spannung durchführen zu können.

Verändert sich der durch die Reihenschaltung der beiden Halbleiter V1, V2 fließende, abzuschaltende Strom, so verändert sich auch die Abschalt- bzw. Abschaltverzugszeit. Dementsprechend treten auch unterschiedliche Spannungsunsymmetrien an der Reihenschaltung auf. Der Verlauf der Abschaltverzugszeit $t_{dq}$ als Funktion des momentanen Abschaltstromes $I_{TQR}$ ist in Fig. 5 dargestellt.

Ergänzend zu dem zu Fig. 4 erläuterten Verfahren, bei dem die Spannungs-Differenzbildner D1, D2 erst nach einem Abschaltvorgang aufgrund der Spannungsdifferenzen die Verzögerungszeit $\Delta$ t1, $\Delta$ t2 bestimmen können, nach der die Feldeffekttransistoren FET1, FET2 angesteuert werden, ist deshalb, wie in Fig. 4 gezeigt, jedem Differenzzeitregler E1, E2 ein Strom-Differenzbildner K1, K2 vorgeschaltet, durch den der Einfluß des abzuschaltenden Laststromes auf die Abschalt- bzw. Abschaltverzugszeit kompensiert wird.

Jeder der Strom-Differenzbildner K1, K2 prüft, ob der momentane Wert des gegenwärtig abzuschaltenden Stromes sich gegenüber dem Stromwert des diesem momentanen leitenden Zustand vorausgegangenen leitenden Zustands der Reihenschaltung verändert hat. Liegt eine Veränderung vor, gibt der Strom-Differenzbildner ein entsprechendes Differenzsignal $\Delta$ I an den an seinen Ausgang angeschlossenen Differenzzeitregler E1, E2, um die vor der gegenwärtigen Leitphase ermittelte Verzugszeit $\Delta$ t1 bzw $\Delta$ t2 entsprechend dem in Fig. 5 gezeigten linearen Zusammenhang zu korrigieren. Die Korrektur, die besonders dann wichtig ist, wenn sich die Last plötzlich ändern kann, kann multiplikativ durchgeführt werden.

Die Strom-Differenzbildner K1, K2 sind zwecks Zufuhr der momentanen Abschaltstromwerte $x_I$ an einen Shunt in der Reihenschaltung angeschlossen.

Die Abgabe des Differenzsignals $\Delta$ I an den jeweiligen Differenzzeitregler E1, E2 ist nur während des leitenden Zustands der Halbleiter V1, V2 möglich, da die Strom-Differenzbildner K1, K2 nur durch den invertierten, den Differenzzeitreglern E1, E2 zugeführten Schaltbefehl "AUS" aktiviert werden.

## Patentansprüche

1. Verfahren zur Vergleichmäßigung der Spannungsaufteilung an einer Reihenschaltung unterschiedlich lange Abschaltzeiten aufweisender, gategesteuerter Halbleiter, an deren Steueranschlüsse infolge des Einschaltens von Schaltelementen durch einen Steuerkreis Abschaltsignale abgegeben werden, und jeweils der Anfang der Abschaltsignale an die zuvor früher abschaltenden Halbleiter solange verzögert wird, bis diese Halbleiter gleichzeitig mit dem Halbleiter mit der längsten Abschaltzeit abschalten,
   **dadurch gekennzeichnet,**
   daß die tatsächliche Spannung an jedem Halbleiter mit dem auf ihn entfallenden Teil der Gesamtspannung an der Reihenschaltung verglichen wird und, sofern die tatsächliche Spannung größer ist, die Verzögerung des Abschaltsignals für diesen Halbleiter entsprechend der festgestellten Spannungsdifferenz so erfolgt, daß die Spannungsdifferenz zu Null wird.

2. Verfahren nach Anspruch 1,
   **dadurch gekennzeichnet,**
   daß die Verzögerung der Abschaltsignale für die früher abschaltenden Halbleiter zunächst bei geringem durch diese fließenden Strom, dann bei höheren Strömen bis schließlich bei vollem Betriebsstrom erfolgt.

3. Verfahren nach einem der Ansprüche 1 oder 2,
   **dadurch gekennzeichnet,**
   daß die jeweils festgelegten Verzögerungszeiten für die Abgabe der Abschaltsignale an die Steueranschlüsse der Halbleiter entsprechend der Differenz der Momentanwerte des durch die Reihenschaltung fließenden Abschaltstromes während zweier aufeinanderfolgender leitender Zustände der Reihenschaltung korrigiert werden.

4. Schaltungsanordnung zur Durchführung des Verfahrens nach einem der Ansprüche 1 bis 3 mit einer Reihenschaltung unterschiedlich lange Abschaltzeiten aufweisender, gategesteuerter Halbleiter, an deren Steueranschlüsse infolge des Einschaltens von Schaltelementen durch einen Steuerkreis Abschaltsignale abgegeben werden, und jeweils der Anfang der Abschaltsignale an die zuvor früher abschaltenden Halbleiter solange verzögert wird, bis diese Halbleiter gleichzeitig mit dem Halbleiter mit der längsten Abschaltzeit abschalten, bei dem für jeden Halbleiter (V1, V2) ein Differenzzeitregler (E1, E2) vorgesehen ist,

- dem eingangsseitig ein Signal (AUS) zum Abschalten des Halbleiters (V1, V2) zuführbar ist,
- der eingangsseitig mit einem Spannungs-Differenzbildner (D1, D2) verbunden ist,
- der ausgangsseitig auf den Steueranschluß (Gate) des Halbleiters (V1, V2) einwirkt und
- dessen Ausgangssignal entsprechend dem vom Spannungs-Differenzbildner (D1, D2) abgegebenen Signal ( U1, U2) verzögert ist,
  **dadurch gekennzeichnet,**
- daß der Spannungs-Differenzbildner (D1, D2) an seinem Ausgang ein der Differenz zwischen der tatsächlichen Spannung ($x_{UD1}$, $x_{UD2}$) am Halbleiter (V1, V2) und dem auf ihn entfallenden Teil ($U_D/2$) der Gesamtspannung ($U_D$) an der Reihenschaltung entsprechendes Signal ($\Delta$ U1, $\Delta$ U2) bereitstellt,
- daß der Differenzzeitregler (E1, E2) ausgangsseitig an den Steueranschluß eines das Abschaltsignal auf den Steueranschluß (Gate) des Halbleiters (V1, V2) schaltenden Schaltelements (FET1, FET2) angeschlossen ist und
- daß das Ausgangssignal des Differenzzeitreglers (E1, E2) entsprechend dem vom Spannungs-Differenzbildner (D1, D2) abgegebenen Signal ($\Delta$ U1, $\Delta$ U2) verzögert ist, sofern die tatsächliche Spannung ($x_{UD1}$, $x_{UD2}$) größer ist als der auf den Halbleiter (V1, V2) entfallende Teil ($U_D/2$) der Gesamtspannung ($U_D$) an der Reihenschaltung.

5. Schaltungsanordnung nach Anspruch 4,
  **dadurch gekennzeichnet,**
  daß die Spannungs-Differenzbildner (D1, D2) und die Differenzzeitregler (E1, E2) aus einer auf dem Kathodenpotential des jeweiligen Halbleiters (V1, V2) liegenden Spannungsquelle gespeist sind und der tatsächliche Wert der Spannung ($x_{UD1}$, $x_{UD2}$) am jeweiligen Halbleiter (V1, V2) über einen Spannungsteiler erfaßt ist.

6. Schaltungsanordnung nach einem der Ansprüche 4 oder 5,
  **dadurch gekennzeichnet,**
  daß die an der Reihenschaltung liegende Spannung ($U_D$) oder der auf den jeweiligen Halbleiter (V1, V2) entfallende Teil ($U_D/2$) der Spannung ($U_D$) über die Hintereinanderschaltung eines Spannungsfrequenzumsetzers (H), eines Optokoppers (G1, G2) und eines Frequenzspannungsumsetzers (F1, F2) zu dem Eingang des jeweiligen Spannungs-Differenzbildners (D1, D2) übertragbar ist.

7. Schaltungsanordnung nach einem der Ansprüche 4 bis 6 zur Durchführung des Verfahrens nach Anspruch 3,
  **dadurch gekennzeichnet,**
  daß der Differenzzeitregler (E1, E2) jedes Halbleiters (V1, V2) eingangsseitig zusätzlich an den Ausgang eines Strom-Differenzbildners (K1, K2) zwischen den Abschaltstrom-Momentanwerten durch die Reihenschaltung während zweier aufeinanderfolgender leitender Zustände der Reihenschaltung angeschlossen sind, wobei der Eingang des Strom-Differenzbildners (K1, K2) nur jeweils während des leitenden Zustands der Reihenschaltung an einen Shunt in derselben geschaltet ist.

## Claims

1. A method for producing a uniform voltage partitioning at a series connection of gate-controlled semiconductors having different turn-off times, at the gate terminals of said semiconductors turn-off signals being delivered, due to the turn-on of switching elements by a control circuit, and the start of each of said turn-off signals at the semiconductors turning-off before being delayed, until said semiconductors turn off simultaneously with the semiconductor having the longest turn-off time,
  characterized by that the actual voltage at each semiconductor is compared to the portion assigned thereto of the total voltage at the series connection, and if the actual voltage is greater, the delay of the turn-off signal for this semiconductor is performed corresponding to the determined voltage difference such that the voltage difference becomes zero.

2. A method according to claim 1,
  characterized by that the delay of the turn-off signals for the semiconductors turning-off before is first performed for low currents flowing therethrough, then for higher currents and finally at full operating current.

3. A method according to one of claims 1 or 2,
  characterized by that the respectively determined delay times for delivering turn-off signals at the gate terminals are corrected corresponding to the difference of the actual values of the turn-off current flowing through the series connection during two successive conducting states of the series connection.

**4.** A circuit for carrying-out the method according to one of claims 1 to 3, having a series connection of gate-controlled semiconductors having different turn-off times, at the gate terminals of said semiconductors turn-off signals being delivered, due to the turn-on of switching elements by a control circuit, and the start of each of said turn-off signals at the semiconductors turning-off before being delayed, until said semiconductors turn-off simultaneously with the semiconductor having the longest turn-off time, wherein for each semiconductor (V1, V2), a differential-time controller (E1, E2) being provided,

- to the input of which a signal (AUS) for turning the semiconductor (V1, V2) off being feedable,
- the input of which being connected to a voltage difference generator (D1, D2),
- the output of which acting on the gate terminal of the semiconductor (V1, V2), and
- the output signal of which being delayed corresponding to the signal (U1, U2) delivered by the voltage difference generator (D1, D2),

characterized by

- that the voltage difference generator (D1, D2) provides, at its output, a signal ($\Delta$ U1, $\Delta$ U2) corresponding to the difference between the actual voltage ($x_{UD1}$, $x_{UD2}$) and the portion ($U_D/2$) assigned thereto of the total voltage ($U_D$) at the series connection,
- that the differential-time controller (E1, E2) is connected at the output side to the gate terminal of a switching element (FET1, FET2) switching the turn-off signal to the gate terminal of the semiconductor (V1, V2), and
- that the output signal of the differential-time controller (E1, E2) is delayed corresponding to the signal ($\Delta$ U1, $\Delta$ U2) delivered by the voltage difference generator (D1, D2), if the actual voltage ($x_{UD1}$, $x_{UD2}$) is greater than the portion ($U_D/2$) assigned thereto of the total voltage ($U_D$) at the series connection.

**5.** A circuit according to claim 4, characterized by that the voltage difference generators (D1, D2) and the differential-time controllers (E1, E2) are supplied by a voltage source being at the cathode potential of the respective semiconductor (V1, V2), and that the actual value of the voltage ($x_{UD1}$, $x_{UD2}$) at the respective semiconductor (V1, V2) is detected over a voltage divider.

**6.** A circuit according to one of claims 4 or 5, characterized by that the voltage ($U_D$) at the series connection or the portion ($U_D/2$) assigned to the respective semiconductor (V1, V2) of the voltage ($U_D$) can be transferred, over the series connection of a voltage-frequency converter (H), an optocoupler (G1, G2) and a frequency-voltage converter (F1, F2), to the input of the respective voltage difference generator (D1, D2).

**7.** A circuit according to one of claims 4 to 6 for carrying-out the method according to claim 3, characterized by that the differential-time controller (E1, E2) of each semiconductor (V1, V2) is additionally connected at the input side to the output of a current difference generator (K1, K2) between the turn-off current actual values by the series connection during two successive conducting states of the series connection, the input of the current difference generator (K1, K2) being connected only during the conducting state of the series connection to a shunt provided therein.

**Revendications**

**1.** Procédé d'uniformisation de la répartition de tension sur un groupement série de semiconducteurs commandés par gâchette, présentant des temps de coupure de longueurs différentes, aux bornes de commandes desquels la mise en circuit d'éléments a pour effet qu'un circuit de commande délivre des signaux de mise hors conduction, le début de ces signaux de mise hors conduction étant retardé pour le semiconducteur qui antérieurement venait hors conduction le plus tôt, ce retard des signaux de mise hors conduction durant jusqu'à ce que lesdits semiconducteurs viennent hors conduction en même temps que le semiconducteur ayant le temps de mise hors conduction le plus long, caractérisé par le fait que la tension effective à chaque semiconducteur est comparée avec la partie qui lui échoit de la tension globale aux bornes du groupement série et, si la tension effective est plus grande, le retard du signal de mise hors conduction pour ce semiconducteur a lieu en correspondance avec la différence de tension constatée, de manière que cette différence de tension soit annulée.

**2.** Procédé selon revendication 1, caractérisé par le fait que le retard des signaux de mise hors conduction concernant les semiconducteurs venant hors conduction plus tôt se produit d'abord pour un faible courant passant par eux, puis pour des courants plus élevés et finalement pour la courant total de fonctionnement.

3. Procédé selon l'une des revendications 1 ou 2, caractérisé
par le fait que les temps de retard constatés à chaque fois pour la délivrance des signaux de mise hors conduction aux bornes de commande des semiconducteurs sont corrigés en fonction de la différence des valeurs momentanées du courant de mise hors conduction passant par le groupement série pendant deux états de conduction consécutifs du groupement série.

4. Dispositif de mise en oeuvre du procédé selon l'une des revendications 1 à 3, avec un groupement série de semiconducteurs commandés par gâchette, présentant des temps de mise hors conduction qui sont de longueurs différentes, les bornes de commande de ces semiconducteurs recevant, sous l'effet de la mise en circuit d'éléments, des signaux de mise hors conduction venant d'un circuit de commande, et le début des signaux de mise hors conduction étant retardé pour les semiconducteurs ayant précédemment été mis hors conduction plus tôt, ce retardement s'étendant jusqu'à ce que ces semiconducteurs viennent hors conduction en même temps que les semiconducteurs ayant le temps de mise hors conduction le plus long, dispositif dans lequel il est prévu, pour chaque semiconducteur (V1, V2), un régulateur de temps différentiel (E1, E2)

- au côté entrée duquel peut être amené un signal (COUPURE) pour la mise hors conduction du semiconducteur (V1, V2),
- dont le côté entrée est relié à un formateur de différence de tensions (D1, D2),
- dont le côté sortie agit sur la borne de commande (gâchette) du semiconducteur (V1, V2) et
- dont le signal de sortie est retardé en correspondance avec le signal (U1, U2) délivré par le formateur de différence de tensions (D1, D2), caractérisé
- par le fait que le formateur de différence de tensions (D1, D2) élabore à sa sortie un signal ($\Delta$U1, $\Delta$U2) correspondant à la différence entre la tension effective ($x_{UD1}$, $x_{UD2}$) aux bornes, du semiconducteur (V1, V2) et la partie qui lui échoit ($U_D$/2) de la tension globale ($U_D$) aux bornes du groupement série,
- par le fait que le régulateur de temps différentiel (E1, E2) est raccordé, côté sortie, à la borne de commande d'un composant (FET1, FET2) commandant le signal de mise hors conduction à l'entrée de commande (gâchette) du semiconducteur (V1, V2), et
- par le fait que le signal de sortie du régulateur de temps différentiel (E1, E2) est retardé en correspondance avec le signal ($\Delta$U1, $\Delta$U2) délivré par le formateur de différence de tensions (D1, D2), cela dans la mesure où la tension effective ($x_{UD1}$, $x_{UD2}$) est plus grande que la partie ($U_D$/2) de la tension globale ($U_D$) du groupement série échoyant au semiconducteur (V1, V2).

5. Dispositif selon revendication 4, caractérisé
par le fait que les formateurs de différence de tension (D1, D2) et les régulateurs de temps différentiel (E1, E2) sont alimentés par une source de tension se trouvant au potentiel de cathode du semiconducteur concerné (V1, V2), et la valeur effective de la tension ($x_{UD1}$, $x_{UD2}$) aux bornes du semiconducteur concerné (V1, V2) est captée par l'intermédiaire d'un diviseur de tension (6).

6. Dispositif selon l'une des revendications 4 ou 5,
caractérisé par le fait que la tension ($U_D$) aux bornes du groupement série, ou la partie ($U_D$/2) de la tension ($U_D$) qui échoit au semiconducteur concerné (V1, V2) peut être transmise dans chaque cas à l'entrée du formateur de différence de tensions (D1, D2) par un montage en cascade d'un convertisseur tension-fréquence (H), d'un optocoupleur (G1, G2) et d'un convertisseur fréquence-tension (F1, F2).

7. Dispositif selon l'une des revendications 4 à 6 pour mettre en oeuvre le procédé selon revendication 3,
caractérisé
par le fait que le régulateur de temps différentiel (E1, E2) de chaque semiconducteur (V1, V2) est en plus raccordé, côté entrée, à la sortie d'un formateur de différence (K1, K2) de courants entre les valeurs momentanées du courant à couper par le groupement série, cela pendant deux états conducteurs consécutifs du groupement série, l'entrée du formateur de différence de courants (K1, K2) n'étant raccordée, que pendant l'état de conduction du groupement série, à un shunt dans ce dernier.

# FIG.1

# FIG.2

EP 0 288 422 B1

FIG.3

# FIG.4

# FIG.5